# EUROPÄISCHE PATENTANMELDUNG

(11) **EP 1 146 551 A1**
(43) Veröffentlichungstag der Anmeldung: **17.10.2001**
(21) Anmeldenummer: 01106304.7
(22) Anmeldetag: 15.03.2001
(51) Int. Cl.: H01L 21/302

(54) **Verfahren zur Überführung einer Rücklaufscheibe in eine Halbleiterscheibe**

(30) Priorität: 13.04.2000 DE 10018339; 31.05.2000 DE 10027103
(71) Anmelder: Wacker Siltronic Gesellschaft für Halbleitermaterialien Aktiengesellschaft, 84489 Burghausen (DE)
(72) Erfinder: Wenski, Guido, Dr., 84489 Burghausen (DE)
(74) Vertreter: Rimböck, Karl-Heinz, Dr.

(57) **Zusammenfassung**

Gegenstand der Erfindung ist ein Verfahren zur Überführung einer als Rücklaufscheibe bezeichneten Halbleiterscheibe in eine Halbleiterscheibe, die als Ausgangsmaterial für die Halbleiterfertigung geeignet ist, wobei die Rücklaufscheibe eine Vorderseite, eine Rückseite und eine Kante besitzt und auf mindestens einer der beiden Seiten Fremdmaterial trägt, das von mindestens einem Prozess zur Herstellung von Halbleiter-Bauelementen stammt. Das Verfahren umfasst folgende Einzelschritte:
(a) mechanische materialabtragende Bearbeitung mindestens einer der das Fremdmaterial tragenden Seite der Rücklaufscheibe;
(b) Abtragen von Oberflächenmaterial von mindestens einer der Seiten und/oder der Kante der Rücklaufscheibe durch mindestens einen Ätzschritt;
(c) Polieren der Kante der Rücklaufscheibe;
(d) gleichzeitiges Polieren der Seiten der Rücklaufscheibe zwischen sich drehenden, mit Poliertuch bedeckten Poliertellern unter Zuführen eines Poliermittels mit einer Feststoffkonzentration von 0,1 bis 5 Gew.-% und einem pH-Wert von 9 bis 12, wobei die Rücklaufscheibe in einer Aussparung einer Läuferscheibe liegt; und
(e) einseitiges Polieren mindestens einer Seite der Rücklaufscheibe auf einem mit Poliertuch bedeckten Polierteller unter Zuführen eines Poliermittels mit einer Feststoffkonzentration von 0,1 bis 5 Gew.-% und einem pH-Wert von 9 bis 12, wobei eine schleierfrei polierte Oberfläche erzeugt wird.

## Beschreibung

Die Erfindung betrifft ein Verfahren zur Überführung einer als Rücklaufscheibe (englisch: reclaim wafer) bezeichneten Halbleiterscheibe in eine Halbleiterscheibe, die als Ausgangsmaterial für die Halbleiterfertigung geeignet ist, insbesondere zur Fabrikation von elektronischen Bauelementen mit Linienbreiten gleich oder kleiner 0,13 µm.

Für die Herstellung von integrierten Halbleiter-Bauelementen werden Halbleiterscheiben benötigt, die je nach Einsatzbereich gewisse Qualitätsanforderungen erfüllen müssen. Einsatzbereiche sind dabei beispielsweise die Herstellung von Datenprozessor- oder Datenspeicher-Bauelementen bestimmter Technologiegenerationen und der Einsatz als Testscheiben, auch Monitorscheiben genannt, zur Kontrolle der Prozesse zur Herstellung derartiger Bauelemente. Qualitätsparameter sind beispielsweise die lokale Ebenheit, ausgedrückt als SFQRₘₐₓ für den schlechtesten Teilbereich der Halbleiterscheibe, die Abwesenheit von visuell sichtbaren Kratzern und Flecken auf der Scheibenoberfläche und die Anzahl von Lichtstreuzentren ("localized light scatterers", LLS) und der Wert der Oberflächenrauigkeit ("Haze") auf der schleierfrei polierten Scheibenseite, in der Regel der Vorderseite, auf welcher die Halbleiter-Bauelemente hergestellt werden sollen. Darüber hinaus wird an Halbleiterscheiben für moderne Bauelementegenerationen, beispielsweise mit Linienbreiten von 0,13 µm und darunter, in der Regel die Forderung nach einer polierten Rückseite und einer polierten Kante gestellt.

Für die Bauelementeherstellung taugliche Halbleiterscheiben besitzen aufgrund der Vielzahl der zu ihrer Bereitstellung notwendigen Prozessschritte einen hohen Wert, wobei der Preis dieses Materials bis zu 10 % der Kosten eines funktionstüchtigen Bauelementes ausmachen kann. Auf der anderen Seite werden im Rahmen einer Bauelementefertigung ständig große Mengen an Halbleiterscheiben aussortiert, die entweder von vorne herein als Monitorscheiben eingesetzt worden sind oder sich aufgrund von Defekten einer Weiterverarbeitung entziehen. Im einfachsten Fall weisen solche Rücklaufscheiben oberflächliche Verunreinigungen oder Defekte auf, die relativ einfach durch Nachreinigung oder Nachpolitur zu beheben sind. Die weitaus meisten derartiger Scheiben sind jedoch mit Fremdmaterial aus den Bauelementeprozessen beaufschlagt, die mit den genannten Verfahren nicht zu vertretbaren Kosten und ohne Qualitätsverluste entfernbar sind. Solches Fremdmaterial kann in Form von Schichten, Schichtfragmenten und Halbleiterkomponenten vorliegen, die sich im Falle der Schichtfragmente und der Halbleiterkomponenten in der Regel auf der Vorderseite, im Falle der Schichten jedoch ebenso auf der Rückseite und der Kante der Scheibe befinden können. Die Gruppe der Schichten und Schichtfragmente kann dabei beispielsweise Halbleitermaterialien, wie epitaktisch aufgewachsene Siliciumschichten, Polysilicium oder Galliumarsenid, Metalle, wie Aluminium, Wolfram und Kupfer, Isolatoren und Dielektrika, wie Siliciumdioxid (SiO₂), Siliciumnitrid (Si₃N₄), Siliciumoxinitride und Phosphosilikate, und Organika, wie Polymere, enthalten. Die Gruppe der Halbleiterkomponenten kann Implantate und Diffusionsbereiche enthalten, beispielsweise mit Bor, Phosphor, Arsen oder Antimon dotiertes Silicium, wobei diese lokal eng begrenzten Bereiche im Gegensatz zu den Schichten und Schichtfragmenten bis zu wenigen µm tief in das Halbleitermaterial der Scheibe hineinreichen können. Die beschriebenen Fremdmaterialien liegen vor allem auf der Vorderseite der Halbleiterscheibe in der Regel in mehreren Schichten gestapelt vor.

Das hohe Kosteneinsparpotential hat dazu geführt, Verfahren für die Aufbereitung von Rücklaufscheiben mit aufgebrachtem Fremdmaterial zu entwickeln, um diese erneut in der Halbleiter-Bauelementeherstellung einsetzen zu können. Nach dem Stand der Technik ist es dabei möglich, zunächst Fremdmaterialschichten durch Ätzen zu entfernen. Beispielsweise lässt sich SiO₂ mit Flusssäure, Si₃N₄ mit heißer konzentrierter Phosphorsäure, poly- und einkristallines Silicium mit einer Flusssäure/Salpetersäure/Essigsäure-Mischung oder heißer konzentrierter Kalilauge (KOH) und organischer Belag mit heißer konzentrierter Schwefelsäure entfernen; diese starken Säuren und Basen werden in wässriger Lösung eingesetzt. Nach dem Ätzen verbleiben in der Regel Halbleiterkomponenten auf der Vorderseite der Halbleiterscheibe.

In der US 3,559,281 ist beansprucht, die ursprünglich epitaxierte Scheibe nach dem Ätzen mit einer Passivierungsschicht beispielsweise aus SiO₂ zu beaufschlagen, diese Schicht von der Rückseite zu entfernen, die Rückseite zu polieren und als Vorderseite für das erneute Aufbringen einer Epitaxieschicht und von Halbleiter-Bauelementen einzusetzen. Ein Nachteil des Verfahrens ist, dass durch die Bedeckung von Halbleiterkomponenten mit der Passivierungsschicht Kontaminationen in der Halbleiterscheibe verbleiben, die in modernen Bauelementeprozessen zu Problemen führen.

In der US 3,923,567 ist vorgeschlagen, nach dem Ätzen zur Erzeugung von Getterzentren eine Phosphordiffusion durchzuführen, die Scheibe erneut zu ätzen und rückseitig zu schleifen und anschließend die Vorderseite zu polieren und für das erneute Aufbringen von Halbleiter-Bauelementen einzusetzen. Ein Nachteil dieses Verfahrens ist, dass zur Entfernung der Getterzentren und zur Gewährleistung der Planparallelität der Halbleiterscheibe relativ hohe Materialabträge erforderlich sind.

In der US 5,131,979 ist zur Aufbereitung von Fremdmaterial-beschichteten Halbleiterscheiben die Schrittfolge Schichtentfernung durch Ätzen oder Schleifen, Kantenschleifen, ein- oder zweistufiges Polieren der Vorderseite, Umverteilung Sauerstoffinduzierter Stapelfehler (OSF) und Aufbringen einer Epitaxieschicht beschrieben. Ein Nachteil dieses Verfahrens ist, dass es mit relativ hohen Umarbeitungskosten verbunden ist.

Gemäß JP-07122532 kann eine Halbleiterscheibe, die lediglich mit einem Polysiliciumfilm und einem SiO₂-Film bedeckt ist, mit dem Ziel einer Wiederverwendung zunächst mit heißer KOH-Lösung von Polysilicium und dann mit einer Flusssäure/Salzsäure-Lösung von SiO₂ befreit und anschließend einseitig auf der später mit Bauelementen zu beaufschlagenden Seite schleierfrei poliert und gereinigt werden. In der EP 933 810 A1 ist die Aufbereitung von SOI-Scheiben ("silicon-on-insulator") nach der Prozessfolge Abätzen oder Abpolieren der einkristallinen Siliciumlage und gegebenenfalls von Fremdmaterialschichten und Entfernung der Isolationsschicht mit Flusssäure beansprucht, wobei sich weitere Schritte wie eine Wärmebehandlung in reduzierender Atmosphäre und/oder eine Politur anschließen können. Ein Nachteil dieser beiden Verfahren ist, dass mit ihnen die Aufbereitung von Halbleiterscheiben mit Bauelementekomponenten nicht möglich ist.

Eine bevorzugte Ausführungsform der US 5,622,875 ist die Prozessfolge Abätzen der Fremdmaterialschichten - Vorderseitenschleifen zur Entfernung der elektronischen Bauelemente-Rückseitenschleifen - Ätzen - Einseiten-Oberflächenpolitur zur Erzeugung einer schleierfrei polierten Rückseite, die bei Wiederverwendung der Halbleiterscheibe in der Bauelementeherstellung als neue Vorderseite definiert wird. Eine bevorzugte Ausführungsform der US 5,855,735 ist die Prozessfolge Kanten-Grobpolitur zur Entfernung von Kantenbeschichtungen - beidseitige Grobpolitur im Läppmodus mit einer Abrasivstoffkonzentration im Poliermittel von größer 6 Vol-% zur Entfernung von Halbleiterkomponenten und Beschichtungen - Ätzen - Einseiten-Oberflächenpolitur zur Erzeugung einer schleierfrei polierten Vorder- oder Rückseite. Ein Nachteil dieser beiden Verfahren ist, dass sie die Bereitstellung einer aufbereiteten Halbleiterscheibe mit einer schleierfrei polierten Seite, einer polierten Seite und einer polierten Kante nicht ermöglichen.

Ein wesentlicher Nachteil aller beschriebenen Verfahren ist, dass sie nicht zu lokalen Ebenheiten führen, wie sie für moderne Bauelementeprozesse erforderlich sind, beispielsweise ausgedrückt als SFQRₘₐₓ gleich oder kleiner 0,13 µm für die Herstellung von elektronischen Bauelementen mit Linienbreiten von 0,13 µm.

Verfahren zum Oberflächenschleifen von Halbleiterscheiben sind beispielsweise in der EP 272 531 A1 und der EP 580 162 A1 beschrieben.Läppverfahren für Halbleiterscheiben sind beispielsweise aus der DE 197 55 705 A1 und der WO 97/28925 bekannt. Ein nasschemische Ätzverfahren ist beispielsweise in der DE 198 33 257 C1 beschrieben. Verfahren zur Kantenpolitur sind beispielsweise aus der US 5,866,477 und der EP 687 524 B1 bekannt. Die Doppelseitenpolitur von Halbleiterscheiben ist beispielsweise in der US 3,691,694, der EP 208 315 B1 und den deutschen Patentanmeldungen mit den Aktenzeichen DE 199 05 737.0 und DE 199 56 250.4 beansprucht. Ein Einseiten-Polierverfahren zur Erzeugung einer schleierfreien Oberfläche ist beispielsweise in der deutschen Patentanmeldung mit dem Aktenzeichen DE-10012840.8 beschrieben. Ein Verfahren zur Herstellung einer Halbleiterscheibe mit einer schleierfrei polierten Vorderseite, einer polierten Rückseite und einer polierten Kante, die den Anforderungen an Halbleiterscheiben für die Herstellung elektronischer Bauelemente mit Linienbreiten von 0,13 µm genügt, ist in der deutschen Patentanmeldung mit dem Aktenzeichen DE-10004578.2 beansprucht.

Es war daher die Aufgabe gestellt, ein Verfahren zur Aufbereitung einer Rücklaufscheibe bereitzustellen, die mit Fremdmaterial aus Prozessen zur Herstellung von elektronischen Bauelementen beaufschlagt und nach der Aufbereitung unter Durchführung einer Dickenreduktion von gleich oder kleiner 50 µm für die Wiederverwendung als Ausgangsmaterial für Bauelemente mit Linienbreiten von gleich oder kleiner 0,13 µm geeignet ist und den bekannten Verfahren der Technik bezüglich der Ausbeuten und der Herstellkosten überlegen ist.

Gegenstand der Erfindung ist ein Verfahren zur Überführung einer als Rücklaufscheibe bezeichneten Halbleiterscheibe in eine Halbleiterscheibe, die als Ausgangsmaterial für die Halbleiterfertigung geeignet ist, wobei die Rücklaufscheibe eine Vorderseite, eine Rückseite und eine Kante besitzt und auf mindestens einer der beiden Seiten Fremdmaterial trägt, das von mindestens einem Prozess zur Herstellung von Halbleiter-Bauelementen stammt, und das Verfahren folgende Einzelschritte umfasst:
(a) mechanische materialabtragende Bearbeitung mindestens einer der das Fremdmaterial tragenden Seite der Rücklaufscheibe;
(b) Abtragen von Oberflächenmaterial von mindestens einer der Seiten und/oder der Kante der Rücklaufscheibe durch mindestens einen Ätzschritt;
(c) Polieren der Kante der Rücklaufscheibe;
(d) gleichzeitiges Polieren der Seiten der Rücklaufscheibe zwischen sich drehenden, mit Poliertuch bedeckten Poliertellern unter Zuführen eines Poliermittels mit einer Feststoffkonzentration von 0,1 bis 5 Gew.-% und einem pH-Wert von 9 bis 12, wobei die Rücklaufscheibe in einer Aussparung einer Läuferscheibe liegt; und
(e) einseitiges Polieren mindestens einer Seite der Rücklaufscheibe auf einem mit Poliertuch bedeckten Polierteller unter Zuführen eines Poliermittels mit einer Feststoffkonzentration von 0,1 bis 5 Gew.-% und einem pH-Wert von 9 bis 12, wobei eine schleierfrei polierte Oberfläche erzeugt wird.

Wesentliches Merkmal der Erfindung ist es, dass durch das Verfahren Halbleiterscheiben mit einer schleierfrei polierten Seite, einer polierten Seite und einer polierten Kante gewonnen werden, die den Anforderungen zur Wiederverwendung bei der Produktion von elektronischen Bauelementen der 0,13-µm-Technologiegeneration genügen. Die Tatsache, dass die erfindungsgemäße Prozesssequenz derartig hochwertige Halbleiterscheiben in hohen Ausbeuten bei Prozesskosten liefert, die mit denen von Aufbereitungsverfahren zur Herstellung qualitativ minderwertigerer Scheiben nach dem Stand der Technik vergleichbar sind, war überraschend und nicht vorhersehbar.

Ausgangsprodukt des Verfahrens ist eine als Rücklaufscheibe bezeichnete, einkristalline Halbleiterscheibe aus einem für die Wiederverwendung geeigneten Material mit einer verrundeten Kante, die in Prozessen zur Herstellung elektronischer Bauelemente auf einer Vorderseite, einer Rückseite und/oder einer Kante mit Fremdmaterial in Form von Schichten, Schichtfragmenten und/oder Halbleiterkomponenten beaufschlagt und von der Weiterverarbeitung ausgeschlossen wurde.

Endprodukt des Verfahrens ist eine einkristalline Halbleiterscheibe mit einer schleierfrei polierten Seite, einer polierten Seite und einer polierten Kante, die erneut zur Herstellung von Halbleiter-Bauelementen der 0,13-µm-Technologiegeneration eingesetzt werden kann und um maximal 50 µm dünner ist als die ursprünglich eingesetzte Halbleiterscheibe.

Das erfindungsgemäße Verfahren kann prinzipiell zur Aufbereitung von scheibenförmigen Körpern eingesetzt werden, die aus einem Material bestehen, welches mit Fremdmaterial beaufschlagt ist und mit den eingesetzten mechanischen, chemischen und chemomechanischen Oberflächen-Bearbeitungsverfahren bearbeitet werden kann. Derartige Materialien sind zum Beispiel Halbleiter wie Silicium oder Galliumarsenid. Das Verfahren eignet sich besonders zur Aufbereitung von mit Fremdmaterial beaufschlagten einkristallinen Siliciumscheiben mit Durchmessern von insbesondere 200 mm, 300 mm, 400 mm und 450 mm und Dicken von 500 µm bis 1000 µm. Erfindungsgemäß aufbereitete Halbleiterscheiben können entweder direkt erneut als Ausgangsmaterial für die Herstellung von Halbleiterbauelementen oder als Monitorscheiben zur Kontrolle dieser Prozesse eingesetzt werden oder nach Aufbringen von Schichten wie Rückseitenversiegelungen oder einer epitaktischen Beschichtung der Scheibenvorderseite beispielsweise mit Silicium und/oder nach Konditionierung durch eine Wärmebehandlung beispielsweise unter Wasserstoff- oder Argonatmosphäre ihrem Bestimmungszweck zugeführt werden. Auch eine Wiederverwendung in Form von SOI-Scheiben ist möglich.

Die weitere Beschreibung des mehrstufigen erfindungsgemäßen Verfahrens erfolgt am Beispiel der Aufbereitung einer Siliciumscheibe als Rücklaufscheibe gemäß der Prozessschritte (a) bis (e) .

### (a) Mechanische Oberflächenbearbeitung

Im Rahmen der Erfindung wird die aufzubereitende Siliciumscheibe zunächst einem mechanischen Oberflächen-Bearbeitungsschritt unterworfen. Dabei kann prinzipiell von der Vorderseite und/oder der Rückseite Material abgetragen werden. Für die mechanische Oberflächenbearbeitung eignen sich beispielsweise Schleif-, Fräs- und Läppverfahren; im Rahmen der Erfindung ist die Ausführung eines Schleif- oder Läppverfahrens bevorzugt. Besonders bevorzugt ist die Anwendung eines Schleifverfahrens auf diejenige Seite, in der Regel die Vorderseite, die neben meist übereinander angeordneten Schichten und Schichtfragmenten auch Bauelementekomponenten wie hochdotierte Implantat- und Diffusionsbereiche trägt, die im Gegensatz zu den Schichten und Schichtfragmenten bis in eine Tiefe von wenigen µm in das einkristalline Silicium hineinragen können. Sollte die gegenüberliegende Scheibenseite, in der Regel die Rückseite, mit einem mehrlagigen Schichtaufbau aus beispielsweise drei oder mehr Schichten oder in Ausnahmefällen ebenfalls mit Bauelementekomponenten beaufschlagt sein, ist bevorzugt, diese Seite ebenfalls zu schleifen oder ein beidseitiges Läppverfahren anzuwenden.

Einseitiges Schleifen der Siliciumscheibe erfolgt durch einen Oberflächen-Schleifschritt besonders bevorzugt in einer Rotationsschleifmaschine mit Hilfe einer Tellerschleifscheibe, die aus Metall-, Kunstharz- oder Keramik-gebundenen Diamanten der Körnung 400 Mesh (Korngrößenbereich 30-50 µm) bis 2000 Mesh (Korngrößenbereich 4-6 µm) besteht; die Verwendung einer Schleifscheibe aus Kunstharz-gebundenen Diamanten ist besonders bevorzugt. Bei Vorliegen der Notwendigkeit, beide Seiten zu schleifen, können diese entweder sequentiell oder gleichzeitig geschliffen oder geläppt werden; sequentielles Oberflächenschleifen ist in diesem Fall besonders bevorzugt. Besonders bevorzugt ist eine Ausführung des Schleifschrittes in der Art, dass in Schichten oder Schichtfragmenten angeordnetes Fremdmaterial von der oder den geschliffenen Seiten der Siliciumscheibe vollständig entfernt wird und der Abtrag an einkristallinem Silicium 1 bis 6 µm pro geschliffene Scheibenseite beträgt.

### (b) Ätzen

Zwecks Entfernung von Schichten auf einer nicht geschliffenen Seite und der Kante der Siliciumscheibe sowie von gestörten Oberflächenschichten ("Damage") und von insbesondere metallischen Verunreinigungen erfolgt an dieser Stelle ein ein- oder mehrstufiger Ätzschritt, der entweder als nasschemische Behandlung der Siliciumscheibe in einer oder mehreren alkalischen und/oder sauren Ätzmischungen und/oder als Plasmabehandlung ausgeführt werden kann. Nasschemisches Ätzen durch Behandlung der gesamten Scheibenoberfläche beispielsweise im Batchverfahren oder nur einer Seite einer einzelnen Siliciumscheibe gegebenenfalls unter Einschluss der Kante beispielsweise mit Hilfe eines sogenannten "Spin Etchers" ist bevorzugt. Für beide Verfahren bietet der Handel Anlagen an. Ist ein mehrstufiges Ätzverfahren notwendig, können die einzelnen Stufen entweder in separaten Ätzanlagen oder in einer integrierten Anlage mit mehreren Ätzbecken ausgeführt werden. Anzahl, Abfolge und Wahl der Chemikalien und Prozessbedingungen der einzelnen Ätzstufen richten sich bevorzugt nach der Beschaffenheit des Ausgangsmaterials. In bestimmten Fällen, insbesondere nach beidseitigem Schleifen in Schritt (a), kann es ausreichen, nur die Kante der Siliciumscheibe zu ätzen.

Der Stand der Technik schlägt zum Abtrag verschiedener Fremdmaterialien verschiedene Ätzmischungen vor, die im Rahmen der Erfindung allesamt bevorzugt sind, wenn ihr Einsatz unter Berücksichtigung des vorliegenden Materials gerechtfertigt ist. Für SiO₂-Schichten eignen sich wässrige Flusssäure (HF), mit Ammoniumfluorid gepufferte wässrige Flusssäure (BHF) oder eine Mischung aus wässriger Flusssäure und Salzsäure in einem Temperaturbereich von 20 bis 60 °C und einer Konzentration von 0,1 bis 10 Gew.-%. Für nitridhaltige Schichten, beispielsweise Si₃N₄ oder Siliciumoxidnitride, wird vorteilhaft heiße konzentrierte Phosphorsäure (H₃PO₄ in wässriger Lösung) in einer Konzentration von 40 bis 95 Gew.-% bei einer Temperatur von 40 bis 190 °C eingesetzt. Unter gewissen Umständen kann zur Entfernung dieser Substanzen ebenfalls HF oder BHF verwendet werden. Für die Entfernung organischer Materialien, beispielsweise Polymere, die als Photomasken bei der Herstellung von Halbleiterstrukturen eingesetzt wurden, kommt konzentrierte Schwefelsäure (60 bis 98 Gew.-% H₂SO₄ in wässriger Lösung) in Frage. Polysilicium und einkristallines Silicium lässt sich durch Säuremischungen auf der Basis von konzentrierter Salpetersäure und konzentrierter Flusssäure bei Temperaturen von 20 bis 60 °C, beispielsweise unter Zugabe von Essigsäure oder säurebeständigen Tensiden, oder in starken Laugen, beispielsweise wässrige Natronlauge (NaOH), Kalilauge (KOH) oder Tetramethylammoniumhydroxidlösung (TMAH) bei Temperaturen von 40 bis 120 °C abätzen. In verschiedenen Fällen können auch Plasmaätzverfahren unter Angriff von neutralen Molekülen oder Ionen im Rahmen der Erfindung eingesetzt werden.

Schritt (b) wird vorzugsweise so ausgeführt, dass zunächst sämtliches auf der Siliciumscheibe noch vorhandenes Fremdmaterial mittels einer oder mehrerer Ätzmischungen entfernt wird. In einer besonders bevorzugten Arbeitsweise erzeugt die letzte Ätzstufe einen Abtrag an einkristallinem Silicium von der Scheibe, um durch den Schleifschritt (a) erzeugtes Damage sowie Kontaminationen zu entfernen. Der Abtrag an einkristallinem Silicium im Ätzschritt (b) beträgt besonders bevorzugt 5 bis 10 µm pro geätzter Scheibenseite.

### (c) Kantenpolitur

Zur Durchführung des Kantenpolierschrittes (c) stehen ebenfalls handelsübliche Automaten zur Verfügung. Bevorzugt wird die Kante der Siliciumscheibe nach dem Ätzschritt (b) entweder mit einem Poliertuch poliert, das über eingebettete feinteilige Abrasivstoffe verfügt, oder mit einem Poliertuch ohne derartige Bestandteile unter kontinuierlicher Zuführung eines wässrigen Poliermittels, das Suspensionen oder Kolloide einer Vielzahl von abrasiv wirkendenden anorganischen Stoffen in Gegenwart von alkalischen Substanzen und gegebenenfalls weitere Zuschlagstoffe enthält. Für die Kantenpolitur geeignete Abrasivstoffe sind beispielsweise SiO₂, Al₂O₃, ZrO₂ und SiC. Besonders bevorzugt wird unter Zuführung eines Poliermittels aus 1 bis 5 Gew.- % SiO₂ in Wasser mit einen pH-Wert von 10 bis 12 mit einem Polyurethan-Poliertuch einer Härte von 30 bis 70 (Shore A) poliert, das verstärkende Polyesterfasern enthalten kann. Der Abtrag an einkristallinem Silicium, bezogen auf die Oberfläche einer Kante, in Schritt (c) beträgt besonders bevorzugt 0,1 bis 5 µm.

### (d) Doppelseitenpolitur

In nachfolgenden Schritt (d) kommt eine handelsübliche Doppelseiten-Poliermaschine im Wesentlichen aus einem frei horizontal drehbaren unteren Polierteller und einem frei horizontal drehbaren oberen Polierteller, die beide mit jeweils einem Poliertuch bedeckt sind, zum Einsatz, die unter kontinuierlicher Zuführung eines Poliermittels geeigneter chemischer Zusammensetzung das beidseitige abtragende Polieren von bevorzugt mehreren Siliciumscheiben erlaubt. Besonders bevorzugt wird mit einem aufgeklebten Polyurethan-Poliertuch einer Härte von 60 bis 90 (Shore A), das gegebenenfalls über eingebaute verstärkende Polyesterfasern verfügen kann, unter Zuführung eines Poliermittels aus 1 bis 5 Gew.-% SiO₂ in Wasser poliert, das durch Kaliumcarbonatzugaben auf einen pH-Wert von 10 bis 11,5 eingestellt wurde.

Die Siliciumscheiben werden dabei durch Läuferscheiben, die über ausreichend dimensionierte Aussparungen zur Aufnahme der Siliciumscheiben verfügen, während des Polierens auf einer Zykloidenbahn gehalten. Läuferscheiben aus rostfreiem Chromstahl sind aufgrund ihrer hohen Maßhaltigkeit und chemischen Resistenz besonders bevorzugt. Um während des Polierens eine Beschädigung der Scheibenkante durch die Innenkante der Aussparung in der Läuferscheibe zu verhindern, ist bevorzugt, die Innenseite der Aussparungen mit einer Kunststoffbeschichtung beispielsweise aus Polyamid von gleicher Dicke wie die Läuferscheibe auszukleiden.

Um nach Schritt (d) Siliciumscheiben mit einer hohen lokalen Ebenheit vorliegen zu haben, ist ein Doppelseiten-Polierverfahren gemäß der deutschen Patentanmeldung mit dem Aktenzeichen 199 05 737.0 besonders bevorzugt, bei welchem sich die gewählte Dicke der Läuferscheiben nach der Enddicke der Siliciumscheiben nach dem Doppelseiten-Polierschritt (d) richtet. Charakteristisch für diese Ausführungsvariante ist, dass die Enddicke der doppelseitenpolierten Siliciumscheiben bevorzugt um 2 µm bis 20 µm größer ist als die Läuferscheibendicke; der besonders bevorzugte Gesamtabtrag an einkristallinem Silicium beträgt 5 bis 20 µm.

Zur Beendigung des Doppelseiten-Polierschrittes (d) muss die chemisch sehr reaktive hydrophobe Scheibenoberfläche passiviert werden. Im Rahmen der Erfindung erfolgt dies bevorzugt durch Zuführung einer Flüssigkeit oder nacheinander mehrerer Flüssigkeiten, die einen oder mehrere filmbildende Stoffe enthalten, mit der Folge einer vollständigen Benetzung von polierter Vorderseite, Rückseite und Kante der Siliciumscheiben mit einem Flüssigkeitsfilm, wobei im Allgemeinen ein Konzentrationsbereich zwischen 0,01 und 10 Vol-% von filmbildendem Stoff im Stoppmittel sinnvoll ist. Besonders bevorzugt im Rahmen der Erfindung ist der Einsatz eines in einer nachfolgenden Reinigung entfernbaren Stoffes oder mehrerer Stoffe aus einer Gruppe von Verbindungen, die ein- oder mehrwertige Alkohole, Polyalkohole und Tenside umfasst. Eine dasselbe Prinzip verwirklichende, ebenfalls besonders bevorzugte Ausführungsform des Stoppvorganges ist die Zuführung eines wässrigen Poliermittels auf SiO₂-Basis, das einen oder mehrere Stoffe aus den genannten Gruppen von Verbindungen in Anteilen von 0,01 bis 10 Vol-% enthält. Die Siliciumscheiben werden nach Beendigung der Zuführung an Stoppmittel und gegebenenfalls Reinstwasser bevorzugt mit Hilfe eines Vakuumsaugers aus der Poliermaschine entnommen und nach dem Stand der Technik gereinigt und getrocknet.

### (e) Oberflächenpolitur

Zur Durchführung des Polierschrittes (e) zur Bereitstellung einer schleierfrei polierten Vorderseite kann eine handelsübliche Oberflächenpoliermaschine mit einem oder mehreren Poliertellern eingesetzt werden, wobei in einem Poliervorgang entweder eine einzelne Siliciumscheibe oder mehrere Siliciumscheiben gleichzeitig poliert werden; beide Vorgehensweisen sind gleichermaßen bevorzugt. Zum Halten der Halbleiterscheiben während der Oberflächenpolitur sind im Rahmen der Erfindung wachsfreie Prozesse bevorzugt. Besonders bevorzugt wird dabei eine oder mehrere Siliciumscheiben durch Anlegen von Vakuum oder/oder durch Wasser-unterstützte Adhäsion von einer mit einem elastischen, porösen Film bedeckten starren Trägerplatte gehalten. Der elastische, zum Kontakt mit der Scheibenrückseite eingesetzte Film ist dabei bevorzugt aus Polymerschaum, besonders bevorzugt aus Polyurethan, gefertigt. Ebenfalls im Rahmen der Erfindung besonders bevorzugt ist der Einsatz einer Trägervorrichtung in Schritt (e), die anstelle der starren Trägerplatte über eine elastische Membran verfügt, die gegebenenfalls mit einer Schutzschicht beaufschlagt wird.

Bei der Oberflächenpolitur (e) kann im Rahmen der Erfindung entweder die Vorderseite oder die Rückseite der Siliciumscheiben schleierfrei poliert werden. Es ist auch möglich, bevorzugt nacheinander beide Seiten schleierfrei zu polieren. In dem Fall, dass das Ausgangsmaterial in Schritt (a) lediglich auf der Vorderseite geschliffen wurde, ist besonders bevorzugt, Schritt (e) auf die Rückseite der Siliciumscheibe anzuwenden, die damit im Rahmen der Wiederverwendung der Scheibe in Halbleiter-Bauelementefertigung als neue Vorderseite definiert wird.

Die Oberflächenpolitur (e) wird vorzugsweise mit einem aufgeklebten weichen Poliertuch unter kontinuierlicher Zuführung eines wässrigen alkalischen Poliermittels auf SiO₂-Basis mit einem Feststoffgehalt von 0,1 bis 5 Gew.-% und einem gegebenenfalls durch Zusatzstoffe auf einen auf 9,5 bis 12 eingestellten pH-Wert poliert. Es besteht jedoch auch die Möglichkeit, nacheinander zwei verschiedene Poliermittel zuzuführen, wobei das erste Poliermittel in einer Konzentration zwischen bevorzugt 1 und 5 Gew.-% SiO₂ eingesetzt wird und vorwiegend einen Abtrag an Halbleitermaterial erzeugt und das zweite Poliermittel in einer Konzentration zwischen bevorzugt 0,1 und 2 Gew.-% SiO₂ eingesetzt wird und vorwiegend eine Glättung der Oberfläche bewirkt. Beide Poliermittel können nacheinander auf einem mit Poliertuch bedeckten Polierteller zugeführt werden. Bevorzugt ist die Verwendung zweier verschiedener Poliermittel in Gestalt eines Zweitellerprozesses, indem auf Teller 1 zunächst mit Poliermittel 1 poliert, der Poliermittelangriff beispielsweise durch Zuführung einer wässrigen Zitronensäurelösung mit einer Konzentration zwischen 0,1 und 20 Gew.-% gestoppt, anschließend auf Teller 2 mit Poliermittel 2 poliert und ebenfalls ein Stoppmittel zugeführt wird, das beispielsweise wie unter Schritt (d) beschrieben bevorzugt einen filmbildenden Stoff enthält. Die beiden Polierteller können dabei mit verschiedenartigen Poliertüchern beklebt sein. Der Siliciumabtrag liegt besonders bevorzugt zwischen 0,1 und 1 µm. Es folgt eine Reinigung und Trocknung der Siliciumscheiben nach dem Stand der Technik, die in Form von Batch- und/oder Einzelscheibenverfahren ausgeführt werden kann.

Es schließt sich eine Bewertung der gemäß der Schritte (a) bis (e) aufbereiteten Siliciumscheiben hinsichtlich von durch den Weiterverarbeiter der Scheiben spezifizierter Qualitätsmerkmale nach dem Fachmann bekannten Methoden an. Geeignete Bewertungsmethoden sind beispielsweise eine Messung der lokalen Geometrie, eine visuelle Prüfung auf Kratzer, Flecken und sonstige unter Neonlicht oder stark gebündeltem Licht ("Hazelicht") sichtbare Abweichungen von der idealen Oberfläche und eine instrumentelle Inspektion vorzugsweise der schleierfrei polierten Seite der Siliciumscheiben mit Hilfe eines handelsüblichen Laser-Detektionsgerätes bezüglich LLS-Zahlen für Streuzentren verschiedener Größenklassen sowie Haze.

Falls notwendig, kann an einer beliebigen Stelle der Prozesskette eine Wärmebehandlung der Siliciumscheiben eingefügt werden, beispielsweise um thermische Donatoren zu vernichten, um eine Störung von oberflächennahen Kristallschichten auszuheilen oder um in letztgenannten Schichten eine gezielte Dotierstoffverarmung herbeizuführen. Weiterhin kann eine Laserbeschriftung zur Scheibenidentifizierung erzeugt werden. Die Aufbringung einer Epitaxieschicht aus Silicium oder weiteren halbleitenden Materialien auf die schleierfrei polierte Seite der Siliciumscheiben, die bei verschiedenen Anwendungen von Vorteil ist, ist ebenfalls möglich.

Erfindungsgemäß aufbereitete Halbleiterscheiben, insbesondere Siliciumscheiben, erfüllen die Anforderungen für die Herstellung von Halbleiterbauelementen mit Linienbreiten gleich oder kleiner 0,13 µm, wenn das Kristallmaterial der ursprünglich eingesetzten und nach Beaufschlagen mit Fremdmaterial aussortierten und aufbereiteten Halbleiterscheibe für einen solchen Einsatz geeignet ist. Nicht naheliegend ist insbesondere, dass das erfindungsgemäße Verfahren die Bereitstellung von Halbleiterscheiben mit einer schleierfrei polierten Seite, einer polierten Seite und einer polierten Kante und einer lokalen Geometrie SFQRₘₐₓ von gleich oder kleiner 0,13 µm selbst dann ermöglicht, wenn die ursprünglich eingesetzte Halbleiterscheibe diese Eigenschaften nicht besaßen. Es hat sich bei typischen Ausbeuten von 85 bis 95 % an für die 0,13-µm-Technologie tauglichen Scheiben als optimale Lösung zur Senkung der Materialkosten in der Halbleiter-Bauelementefertigung erwiesen. Die Anwendung von Kostenrechnungsmodellen belegt, dass das erfindungsgemäße Aufbereitungsverfahren für Halbleiterscheiben mit den Verfahren nach dem Stand der Technik vergleichbar ist, dabei jedoch ein qualitativ höherwertiges Produkt erzeugt.

Zur Beschreibung und zum aufgeführten Beispiel gehören Figuren, welche die Erfindung verdeutlichen, jedoch keine Einschränkung bedeuten.

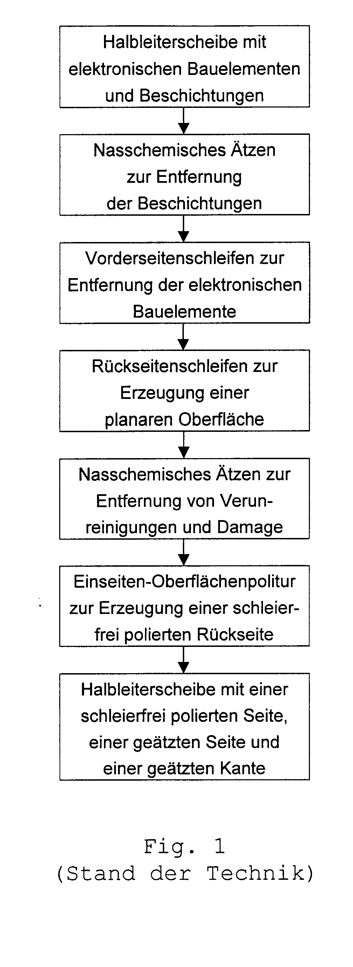

Fig. 1 zeigt eine Prozessabfolge zur Aufbereitung einer beschichteten Halbleiterscheibe nach dem Stand der Technik, die zu einer Halbleiterscheibe mit einer schleierfrei polierten Seite, einer geätzten Seite und einer geätzten Kante führt.

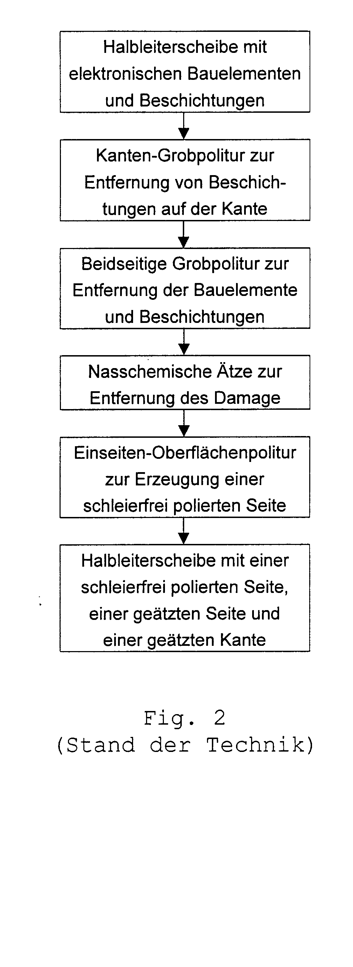

Fig. 2 zeigt eine weitere Prozessabfolge zur Aufbereitung einer beschichteten Halbleiterscheibe nach dem Stand der Technik, die zu einer Halbleiterscheibe mit einer schleierfrei polierten Seite, einer geätzten Seite und einer geätzten Kante führt.

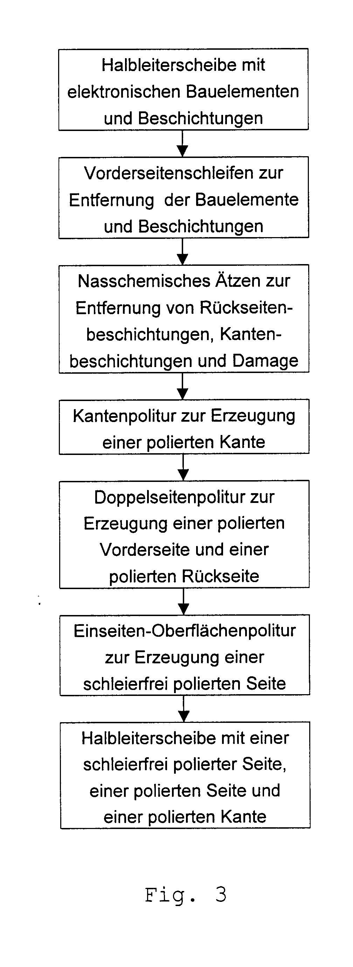

Fig. 3 zeigt eine bevorzugte erfindungsgemäße Prozessabfolge zur Aufbereitung einer beschichteten Halbleiterscheibe, die zu einer Halbleiterscheibe mit einer schleierfrei polierten Seite, einer polierten Seite und einer polierten Kante führt und im angegebenen Beispiel ausgeführt wurde.

### Beispiel

Es standen schwach Bor-dotierte Siliciumscheiben (Widerstand 10-20 Ω·cm; Durchmesser 300 mm) zur Verfügung, die mit schleierfrei polierter Vorderseite, polierter Rückseite, polierter Kante und einer Dicke von 775 µm in eine Halbleiter-Bauelementefertigung gemäß .der 0,13-um-Technologiegeneration geliefert worden und aus Qualitätsgründen ausgefallen waren. Die Scheiben waren wie folgt mit Fremdmaterial beaufschlagt: Die Vorderseite war mit Diffusionsbereichen (Silicium, dotiert mit Bor beziehungsweise Phosphor) sowie Schichten und Schichtfragmenten (SiO₂, Si₃N₄, Polysilicium und Aluminium) belegt. Die Kante und die Rückseite waren mit SiO₂ belegt.

### (a) Oberflächenschleifen der Vorderseite

Auf einer Rotationsschleifmaschine wurde die Vorderseite der Halbleiterscheiben mittels eines Oberflächen-Schleifschrittes bearbeitet, wobei eine Kunstharz-gebundene Tellerschleifscheibe mit Diamanten der Körnung 600 Mesh (Korngrößenbereich 20-30 µm) zum Einsatz kam. Der Schleifabtrag wurde so bemessen, dass sämtliches Fremdmaterial einschließlich der Diffusionsbereiche von der Vorderseite entfernt wurde, wobei neben den Fremdmaterialien 5 µm von der Siliciumscheibe abgeschliffen wurden.

### (b) Nasschemisches Ätzen

In einer integrierten Ätzanlage folgte zwecks Entfernung der SiO₂-Beschichtung von Kante und Rückseite ein Eintauchen von jeweils 26 Siliciumscheiben in einem Ätzmagazin aus Polyvinylidendifluorid (PVDF) in eine auf 50 °C temperierte wässrige Flusssäurelösung (1 Gew.-%). Nach vollständiger Entfernung der SiO₂-Schicht, wobei kein nennenswerter Abtrag von der Siliciumscheibe stattfand, wurden die Scheiben trocken und hydrophob in einen mit Ozon gefüllten Gasraum gehoben und so gleichförmig hydrophiliert. Unmittelbar daran schloss sich ein saurer Ätzschritt nach dem Strömungsätzverfahren an, wobei durch Eintauchen der sich drehenden Scheiben in einer auf 20 °C temperierten Mischung aus 90 Gew.-% konzentrierter Salpetersäure (70 Gew.-% in wässriger Lösung), 10 Gew.-% konzentrierter Flusssäure (50 Gew.-% in wässriger Lösung) und 0,1 Gew.-% Ammoniumlaurylsulfat pro Scheibenseite gleichzeitig je 5 µm Silicium abgetragen wurden. Nach Umsetzen des Scheibenpaketes in eine insgesamt 3mal mit Reinstwasser befüllte Quickdump-Spüle wurden die Scheiben in einem ebenfalls nach dem Flusssäure/Ozon-Prinzip arbeitenden Trockner getrocknet; die Temperatur der 0,5 Gew.-%igen wässrigen Flusssäurelösung betrug dabei 20 °C.

### (c) Kantenpolitur

Die Kanten der gemäß der Schritte (a) und (b) geschliffenen und geätzten Scheiben wurden auf einer Kantenpolieranlage für 300-mm-Scheiben mit einem wässrigren Poliermittel des Typs Levasil 200 von Fa. Bayer mit einem SiO₂-Feststoffgehalt von 3 Gew.-% und einem durch Kaliumcarbonatzugabe auf einen auf 10,5 eingestellten pH-Wert poliert, wobei ein mit Polyesterfasern verstärktes Polyurethan-Poliertuch mit der Härte 50 (Shore A) zum Einsatz kam. Dabei wurde nacheinander durch Rotation der Siliciumscheibe mit einem schräg angestellten, mit Poliertuch beklebten Polierteller zunächst die untere und anschließend die obere Flanke der Scheibenkante poliert.

### (d) Doppelseitenpolitur

Die Dicke der zum Doppelseiten-Polierschritt (d) angelieferten Siliciumscheiben betrug 760 µm. Für die Doppelseitenpolitur standen fünf Läuferscheiben aus rostfreiem Chromstahl mit einer Dicke von 740 µm zur Verfügung, die über jeweils drei kreisförmige, in gleichen Abständen auf einer Kreisbahn angeordnete, mit Polyamid ausgekleidete Aussparungen vom Innendurchmesser 301 mm verfügten und die gleichzeitige Politur von 15 300-mm-Siliciumscheiben ermöglichten. Es wurde mit einem handelsüblichen Poliertuch aus porösem Polyurethanschaum der Härte 80 (Shore A), welches jeweils auf dem oberen und dem unteren Polierteller aufgeklebt war, unter Verwendung eines wässrigen Poliermittels des Typs Levasil 200 von Fa. Bayer mit einem SiO₂-Feststoffgehalt von 3 Gew.-% und einem durch Kaliumcarbonatzugabe auf einen auf 10,5 eingestellten pH-Wert unter einem Anpressdruck von 0,15 bar poliert. Die Politur erfolgte bei einer Temperatur des oberen und des unteren Poliertellers von jeweils 40 °C und führte zu einer Abtragsrate von 0,63 µm/min.

Die Zuführung des Poliermittels wurde nach Erreichen einer Dicke der polierten Scheiben von 745 µm beendet, was einem Siliciumabtrag von 15 µm entspricht, und zum Stoppen des Polierprozesses durch sequenzielle Zuführung der nachfolgend aufgeführten Flüssigkeiten unter Beibehaltung der Rotationsverhältnisse ersetzt: (1) 2 Gew.-%ige Mischung des Poliermittels Glanzox 3900 von Fa. Fujimi mit Reinstwasser (3 min; 0,05 bar); (2) Reinstwasser (2 min; 0,03 bar); (3) wässrige Lösung von 1 Vol-% Glycerin, 1 Vol-% n-Butanol und 0,07 Vol-% des Tensids Silapur (Alkylbenzolsulfonsäure/Aminethoxylat, Hersteller Fa. ICB; 2 min; 0,03 bar). Nach dem Hochfahren und Ausschwenken des oberen Poliertellers waren die Vorderseiten der fertig polierten, in den Läuferscheibenaussparungen positionierten Siliciumscheiben vollständig mit Stoppflüssigkeit benetzt.

Zur Entnahme der Siliciumscheiben aus der Doppelseiten-Poliermaschine stand ein mit einem Haltegriff versehener Vakuumsauger aus Polypropylen zur Verfügung, der über drei Saugnäpfe aus Weich-PVC verfügte. Außerdem stand ein handelsüblicher 300-mm-Nasseinhorder zur Aufnahme der polierten Siliciumscheiben zur Verfügung, der mit Reinstwasser gefüllt war. Es wurde so vorgegangen, dass die Läuferscheiben bei der Scheibenentnahme in ihrer Position belassen wurden und die Scheibenentnahme und Überführung in den Nasseinhorder einzeln mit Hilfe des Vakuumsaugers durchgeführt wurde. Die Siliciumscheiben wurden anschließend nach dem Stand der Technik im Batchverfahren gereinigt und getrocknet.

### Oberflächenpolitur (e)

Ein Oberflächen-Polierschritt (e) zur Erzeugung einer schleierfrei polierten Seite wurde auf der Rückseite der Siliciumscheiben, also der Seite, die vor Ausführung der Schritte (a) bis (d) nicht mit Diffusionsbereichen beaufschlagt war, durchgeführt. Durch diese Vorgehensweise wurde die ursprüngliche Rückseite als neue Vorderseite der Scheiben definiert. Für Schritt (e) stand eine Einzelscheiben-Poliermaschine mit zwei getrennten Poliertellern und einer rotierenden Trägervorrichtung für Halbleiterscheiben des Durchmessers 300 mm zur Verfügung, die im Wesentlichen aus einer mit einem elastischen Polyurethanfilm beklebten starren Trägerplatte und einem ebenfalls aufgeklebten seitlichen Begrenzungsring aufgebaut war. Die Trägervorrichtung wurde nach Anschrauben der Basisplatte an die Polierspindel der Anlage befestigt.

Es wurde ein Zweistufen-Polierprozess ausgeführt, indem die neue Vorderseite der Siliciumscheiben zunächst auf Teller 1 und nach Durchführung einer kurzen Zwischenreinigung in Reinstwasser unmittelbar anschließend auf Teller 2 poliert wurde, woran sich eine Reinigung und Trocknung zunächst in einem Einzelscheibenprozess und anschließend in einem Batchverfahren anschloss. Auf Teller 1 wurde mit einem Polytex-Poliertuch von Fa. Rodel unter Zugabe des Poliermittels Levasil 300 (3 Gew.-% SiO₂ in Reinstwasser; pH-Wert durch K₂CO₃-Zugabe auf 10,5 eingestellt) für eine Zeitdauer von 3 min poliert. Anschließend wurde zum Stoppen des Poliervorganges unter weiterer Drehung von Polierteller und Spindel für eine Zeitdauer von 20 sec eine Lösung von 10 Gew.-% Zitronensäure in Reinstwasser und für weitere 15 sec Reinstwasser ohne Zusätze zugeführt. Teller 2 war mit einem Poliertuch des Typs Napcon 4500 N2 von Fa. Nagase beklebt. Zur Ausführung des zweiten, glättenden Polierschrittes wurde das Poliermittel Glanzox 3900 (1 Gew.-% SiO₂ in Reinstwasser; pH-Wert 9,8) für eine Zeitdauer von 2 min zugeführt, gefolgt von einer Zuführung von Reinstwasser für eine Zeitdauer von 30 sec unter fortgesetzter Drehung von Polierteller und Spindel. Der Gesamt-Siliciumabtrag von der Vorderseite der Halbleiterscheibe betrug 0,6 µm. Die so aufbereiteten Scheiben besaßen eine Dicke von 744 µm; der Gesamt-Siliciumabtrag betrug somit 31 µm.

Die gemäß der Schritte (a) bis (e) prozessierten Siliciumscheiben besaßen gemäß einer Geometriemessung auf einem nach dem kapazitiven Messprinzip arbeitenden Gerät eine Ebenheit SFQRₘₐₓ von (0,11±0,02) µm. Es folgte eine visuelle Oberflächenbeurteilung von Vorder- und Rückseite der Siliciumscheiben unter Hazelicht in einer abgedunkelten Beurteilungskammer in Bezug auf Kratzer und Flecken und anschließend eine instrumentelle Oberflächenbeurteilung der schleierfrei polierten neuen Vorderseite auf einem Oberflächen-Laserinspektionsgerät des Typs SP1 von Fa. KLA Tencor hinsichtlich Haze und Anzahl an LLS mit einem Durchmesser von gleich oder größer 0,12 µm jeweils im DNN-Kanal. Dabei zeigte sich, dass 92 % - bezogen auf die in Schritt (a) eingesetzte Scheibenanzahl - der Siliciumscheiben nach Schritt (e) die für Bauelementeprozesse der 0,13-µm-Technologiegeneration geforderte Spezifikation Kratzer- und Fleckenfreiheit auf Vorder- und Rückseite sowie Haze gleich oder kleiner 0,065 ppm und maximal 100 LLS gleich oder größer 0,12 µm auf der neuen Vorderseite erfüllen und somit für eine Wiederverwendung in der Halbleiter-Bauelementeherstellung geeignet sind.

## Patentansprüche

1. Verfahren zur Überführung einer als Rücklaufscheibe bezeichneten Halbleiterscheibe in eine Halbleiterscheibe, die als Ausgangsmaterial für die Halbleiterfertigung geeignet ist, wobei die Rücklaufscheibe eine Vorderseite, eine Rückseite und eine Kante besitzt und auf mindestens einer der beiden Seiten Fremdmaterial trägt, das von mindestens einem Prozess zur Herstellung von Halbleiter-Bauelementen stammt, und das Verfahren folgende Einzelschritte umfasst:
(a) mechanische materialabtragende Bearbeitung mindestens einer der das Fremdmaterial tragenden Seite der Rücklaufscheibe;
(b) Abtragen von Oberflächenmaterial von mindestens einer der Seiten und/oder der Kante der Rücklaufscheibe durch mindestens einen Ätzschritt;
(c) Polieren der Kante der Rücklaufscheibe;
(d) gleichzeitiges Polieren der Seiten der Rücklaufscheibe zwischen sich drehenden, mit Poliertuch bedeckten Poliertellern unter Zuführen eines Poliermittels mit einer Feststoffkonzentration von 0,1 bis 5 Gew.-% und einem pH-Wert von 9 bis 12, wobei die Rücklaufscheibe in einer Aussparung einer Läuferscheibe liegt; und
(e) einseitiges Polieren mindestens einer Seite der Rücklaufscheibe auf einem mit Poliertuch bedeckten Polierteller unter Zuführen eines Poliermittels mit einer Feststoffkonzentration von 0,1 bis 5 Gew.-% und einem pH-Wert von 9 bis 12, wobei eine schleierfrei polierte Oberfläche erzeugt wird.

2. Verfahren nach Anspruch 1, **dadurch gekennzeichnet, dass** das Fremdmaterial zu der Gruppe der Materialien zählt, die Schichten, Schichtfragmente und Halbleiterkomponenten enthält.

3. Verfahren nach Anspruch 2, **dadurch gekennzeichnet, dass** die Gruppe der Schichten und Schichtfragmente Halbleitermaterialien, Metalle, Isolatoren, Dielektrika und Organika und die Gruppe der Halbleiterkomponenten Implantate und Diffusionsbereiche enthält.

4. Verfahren nach einem der Ansprüche 1 bis 3, **dadurch gekennzeichnet, dass** die Rückseite der Rücklaufscheibe frei von Halbleiterkomponenten ist.

5. Verfahren nach einem der Ansprüche 1 bis 4, **dadurch gekennzeichnet, dass** Schritt (a) als Schleifschritt oder als Läppschritt ausgeführt wird.

6. Verfahren nach einem der Ansprüche 1 bis 5, **dadurch gekennzeichnet, dass** Schritt (a) als Oberflächen-Schleifschritt mindestens der Vorderseite der Rücklaufscheibe ausgeführt wird, wobei das Fremdmaterial vollständig von der Vorderseite und der Rückseite abgetragen wird.

7. Verfahren nach einem der Ansprüche 1 bis 5, **dadurch gekennzeichnet, dass** Schritt (a) als Doppelseiten-Schleifschritt ausgeführt wird, wobei das Fremdmaterial vollständig von der Vorderseite und der Rückseite abgetragen wird.

8. Verfahren nach einem der Ansprüche 6 oder 7, **dadurch gekennzeichnet, dass** in Schritt (a) 1 bis 6 µm einkristallines Halbleitermaterial pro geschliffene Scheibenseite abgetragen wird.

9. Verfahren nach einem der Ansprüche 1 bis 7, **dadurch gekennzeichnet, dass** in Schritt (b) mindestens ein nasschemischer Ätzschritt ausgeführt wird.

10. Verfahren nach Anspruch 9, **dadurch gekennzeichnet, dass** zur Durchführung des nasschemischen Ätzschrittes (b) eine wässrige Mischung mit mindestens einer starken Säure oder mindestens einer starken Base zum Einsatz kommt.

11. Verfahren nach einem der Ansprüche 9 oder 10, **dadurch gekennzeichnet, dass** in Schritt (b) 5 bis 10 µm einkristallines Halbleitermaterial pro geätzte Scheibenseite abgetragen wird.

12. Verfahren nach einem der Ansprüche 1 bis 11, **dadurch gekennzeichnet, dass** in Schritt (c) mit einem Poliertuch unter Zuführen eines Poliermittels mit einer Feststoffkonzentration von 0,1 bis 5 Gew.-% und einem pH-Wert von 9 bis 12 poliert wird.

13. Verfahren nach einem der Ansprüche 1 bis 12, **dadurch gekennzeichnet, dass** das in den Schritten (c), (d) und (e) eingesetzte wässrige Poliermittel Siliciumdioxid als Feststoff enthält.

14. Verfahren nach einem der Ansprüche 1 bis 12, **dadurch gekennzeichnet, dass** in Schritt (c) mit einem Poliertuch poliert wird, das Abrasivstoffe enthält.

15. Verfahren nach einem der Ansprüche 1 bis 14, **dadurch gekennzeichnet, dass** in Schritt (d) der Materialabtrag 2 µm bis 40 µm beträgt und die eingesetzte Läuferscheibe eine um 2 µm bis 20 µm geringere Dicke besitzt als die fertig polierte Rücklaufscheibe.

16. Verfahren nach einem der Ansprüche 1 bis 15, **dadurch gekennzeichnet, dass** in Schritt (d) zum Stoppen des Poliervorganges mindestens eine Flüssigkeit zugeführt wird, die mindestens einen filmbildenden Stoff enthält.

17. Verfahren nach einem der Ansprüche 1 bis 16, **dadurch gekennzeichnet, dass** Schritt (e) als Einstufenprozess auf einem mit Poliertuch bespannten Polierteller ausgeführt wird.

18. Verfahren nach einem der Ansprüche 1 bis 16, **dadurch gekennzeichnet, dass** Schritt (e) als Zweistufenprozess auf zwei getrennten mit Poliertuch bespannten Poliertellern ausgeführt wird.

19. Verfahren nach einem der Ansprüche 1 bis 18, **dadurch gekennzeichnet, dass** in Schritt (e) ein Materialabtrag von 0,1 µm bis 1 µm erzielt wird.

20. Verfahren nach einem der Ansprüche 1 bis 19, **dadurch gekennzeichnet, dass** in Schritt (e) zum Stoppen des Poliervorganges eine Flüssigkeit zugeführt wird, die mindestens einen filmbildenden Stoff enthält und/oder einen pH-Wert von 2 bis 8 besitzt.

21. Verfahren nach einem der Ansprüche 1 bis 20, **dadurch gekennzeichnet, dass** ein Gesamtabtrag an einkristallinem Halbleitermaterial nach Ausführung der Schritte (a) bis (e) 15 µm bis 50 µm beträgt.

22. Verfahren nach einem der Ansprüche 1 bis 21, **dadurch gekennzeichnet, dass** nach Durchführung der Verfahrensschritte (a) bis (e) auf einer schleierfrei polierten Seite der Rücklaufscheibe eine halbleitende epitaktische Beschichtung aufgebracht wird.

23. Verfahren nach einem der Ansprüche 1 bis 22, **dadurch gekennzeichnet, dass** die Rücklaufscheibe aus Silicium besteht.

24. Verfahren nach einem der Ansprüche 1 bis 23, **dadurch gekennzeichnet, dass** die aus der Rücklaufscheibe hervorgehende Halbleiterscheibe eine lokale Ebenheit SFQRₘₐₓ von gleich oder kleiner 0,13 µm, bezogen auf eine Bauelementefläche von 25 mm x 25 mm, besitzt.
